# EUROPEAN PATENT APPLICATION

(11) **EP 3 929 990 A1**
(43) Date of publication of application: **29.12.2021**
(21) Application number: 20759037.3
(22) Date of filing: 06.02.2020
(51) Int. Cl.: H01L 27/15, H01L 27/12, H01L 21/8234, H01L 21/768

(54) **DISPLAY DEVICE USING SEMICONDUCTOR LIGHT EMITTING ELEMENT, AND METHOD FOR PRODUCING SAME**

(30) Priority: 20.02.2019 KR 20190020048
(71) Applicant: LG Electronics Inc., Seoul 07336 (KR)
(72) Inventor: MOON, Seongmin, Seoul 06772 (KR); PARK, Changseo, Seoul 06772 (KR); JEON, Kiseong, Seoul 06772 (KR)
(74) Representative: Vossius & Partner Patentanwälte Rechtsanwälte mbB
(86) International application number: PCT/KR2020/001695
(87) International publication number: WO 2020/171437

(57) **Abstract**

The present invention provides a display device characterized by having: a substrate; a plurality of partition walls disposed on the substrate; a plurality of semiconductor light emitting elements disposed on the substrate and disposed between the partition walls; and a passivation layer covering at least a portion of the semiconductor light emitting elements and at least a portion of the partition walls, wherein the passivation layer extends from the side surfaces of the partition walls toward the semiconductor light emitting elements to cover at least a portion of the side surfaces of the partition walls and at least a portion of the semiconductor light emitting elements.

## Description

### TECHNICAL FIELD

The present disclosure relates to a display device and a method for manufacturing the same, and more particularly, to a display device using semiconductor light emitting elements or devices.

### BACKGROUND ART

The current competing technologies for large area display are liquid crystal displays (LCD), organic light emitting diode (OLED) displays, and micro-LED displays.

The use of semiconductor light emitting diodes (micro-LEDs (uLEDs)) with a diameter or cross-sectional area of 100 microns or less in a display may provide a very high efficiency because the display does not use a polarizer to absorb light. However, since large displays require millions of LEDs, it has difficulty in transferring the LEDs compared to other technologies.

Pick and place, laser lift-off (LLO), self-assembly, and the like have been developed for transfer techniques. Among them, the self-assembly technique, which is a method in which the semiconductor light emitting diodes are self-organized in a fluid, is the most advantageous method for realizing a large screen display device.

U.S. Patent No. 9,825,202, which is hereby incorporated by reference, discloses a micro-LED structure suitable for self-assembly, however, research on manufacturing a display using self-assembly of micro-LEDs is not sufficient. Therefore, the present disclosure provides a new type of display device in which micro-LEDs can be self-assembled and a method for manufacturing the same.

### SUMMARY

The present disclosure describes a new manufacturing process that can provide high reliability in a large screen display using micro-semiconductor light emitting elements.

The present disclosure also describes a manufacturing process of a display that can enable semiconductor light emitting elements to be self-assembled directly on a wiring substrate.

The present disclosure also describes a structure and a manufacturing process that can prevent semiconductor light emitting elements from being separated from their predetermined positions during a post-process after self-assembling the semiconductor light emitting elements.

According to one aspect of the subject matter described in this application, a display device includes: a substrate; a plurality of partition walls disposed on the substrate; a plurality of semiconductor light emitting elements disposed on the substrate and disposed between the partition walls; and a passivation layer covering at least parts of the semiconductor light emitting elements and at least parts of the partition walls. The passivation layer extends from side surfaces of the plurality of partition walls in a direction toward the plurality of semiconductor light emitting elements, so as to cover at least parts of the side surfaces of the plurality of partition walls and at least parts of the plurality of semiconductor light emitting elements.

Implementations according to this aspect may include one or more of the following features. For example, the present disclosure may further include an optical gap layer covering the passivation layer, and a first wiring electrode and a second wiring electrode formed on the optical gap layer and electrically connected to the plurality of semiconductor light emitting elements.

In some implementations, parts of the first and second wiring electrodes may overlap the passivation layer.

In some implementations, a part of the passivation layer may cover the substrate.

In some implementations, the passivation layer may extend from side surfaces of the plurality of partition walls to the substrate, and extend from the substrate to side surfaces of the plurality of semiconductor light emitting elements.

In some implementations, the passivation layer may include a first passivation layer covering parts of the plurality of semiconductor light emitting elements, and a second passivation layer covering at least a part of the first passivation layer and at least parts of the plurality of partition walls.

In some implementations, the first passivation layer and the second passivation layer may be made of different materials having different refractive indices.

According to another aspect, a method of self-assembling semiconductor light emitting elements includes the steps of: disposing a plurality of partition walls on a substrate; transferring the substrate to an assembly position and putting the semiconductor light emitting elements each having a magnetic body into a fluid chamber; applying a magnetic force to the semiconductor light emitting elements so as to allow the semiconductor light emitting elements to move along one direction in the fluid chamber; applying an electric field to guide the semiconductor light emitting elements between the partition walls while moving, so that the semiconductor light emitting elements are placed between the partition walls; and forming a passivation layer covering at least parts of the plurality of partition walls and at least parts of the semiconductor light emitting elements, so that the semiconductor light emitting elements placed between the partition walls are fixed.

Implementations according to this aspect may include one or more of the following features. For example, the method may further include forming an optical gap layer covering the passivation layer.

According to the present disclosure having the above configuration, a large number of semiconductor light emitting elements may be assembled at once in a display device in which individual pixels are configured as micro-LEDs.

According to the present disclosure, a large number of semiconductor light emitting elements may be pixelated on a wafer having the small size and may then be directly transferred onto a substrate with the large area. In addition, as the mesa of the semiconductor light emitting elements is performed on the substrate, the semiconductor light emitting elements may be directly transferred onto a wiring substrate without using a temporary substrate. Thus, a large area display device may be manufactured at a low cost.

According to the manufacturing method and the device of the present disclosure, semiconductor light emitting elements may be simultaneously transferred to designated or accurate positions in a solution using a magnetic field and an electric field, thereby achieving low cost, high efficiency, and high-speed transfer implementation regardless of the size and the number parts, and the transfer area.

Since the assembly is done by an electric field, selective assembly may be enabled through selective electric application without any additional device or process. Accordingly, red, green, and blue micro-LEDs may be selectively assembled at desired positions.

According to the present disclosure, as semiconductor light emitting elements are temporarily fixed by a passivation layer formed immediately after self-assembly, it is possible to prevent the semiconductor light emitting elements from being separated from designated positions in a process subsequent to the self-assembly.

### BRIEF DESCRIPTION OF THE DRAWINGS

FIG. 1 is a schematic view illustrating a display device using a semiconductor light emitting element according to one implementation of the present disclosure.
FIG. 2 is a partially enlarged view of a portion "A" of the display device in FIG. 1.
FIG. 3 is an enlarged view of a semiconductor light emitting element of FIG. 2.
FIG. 4 is an enlarged view illustrating another implementation of the semiconductor light emitting element of FIG. 2.
FIGS. 5A to 5E are schematic views for explaining a new process of fabricating the semiconductor light emitting element.
FIG. 6 is a schematic view showing an example of a self-assembly device for a semiconductor light emitting element according to the present disclosure.
FIG. 7 is a block diagram illustrating the self-assembly device of FIG. 6.
FIGS. 8A to 8G are schematic views illustrating a process of self-assembling semiconductor light emitting elements using the self-assembly device of FIG. 6.
FIGS. 9A to 9E are schematic views illustrating a process of manufacturing a display device after self-assembling semiconductor light emitting elements to a wiring substrate using the self-assembly device of FIG. 6.
FIGS. 10A to 10E are schematic views illustrating a modified example of the present disclosure.

### DETAILED DESCRIPTION

Description will now be given in detail according to exemplary embodiments disclosed herein, with reference to the accompanying drawings. For the sake of brief description with reference to the drawings, the same or equivalent components may be provided with the same or similar reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In describing the present disclosure, if a detailed explanation for a related known function or construction is considered to unnecessarily divert the main point of the present disclosure, such explanation has been omitted but would be understood by those skilled in the art. The accompanying drawings are used to help easily understand the technical idea of the present disclosure and it should be understood that the idea of the present disclosure is not limited by the accompanying drawings.

It will be understood that when an element such as a layer, area or substrate is referred to as being "on" another element, it can be directly on the element, or one or more intervening elements may also be present.

A display device disclosed herein may include a mobile phone, a smart phone, a laptop computer, a digital broadcast terminal, a personal digital assistant (PDA), a portable multimedia player (PMP), a navigator, a slate PC, a tablet PC, an ultrabook, a digital TV, digital signage, a head mounted display (HMD), a desktop computer, and the like. However, it would be readily apparent to those skilled in the art that the configuration according to the implementations described herein may also be applied to a new product type of display device that will be developed later.

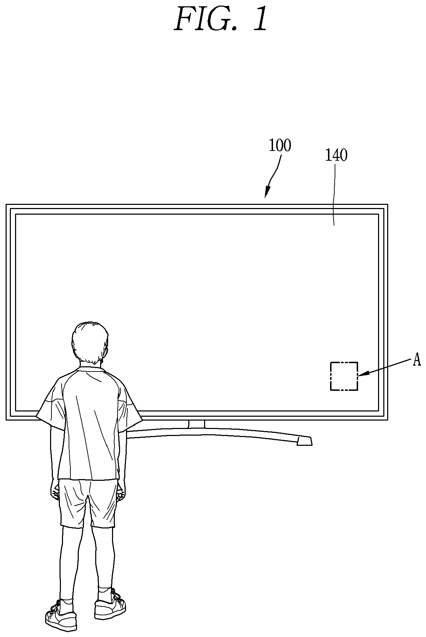

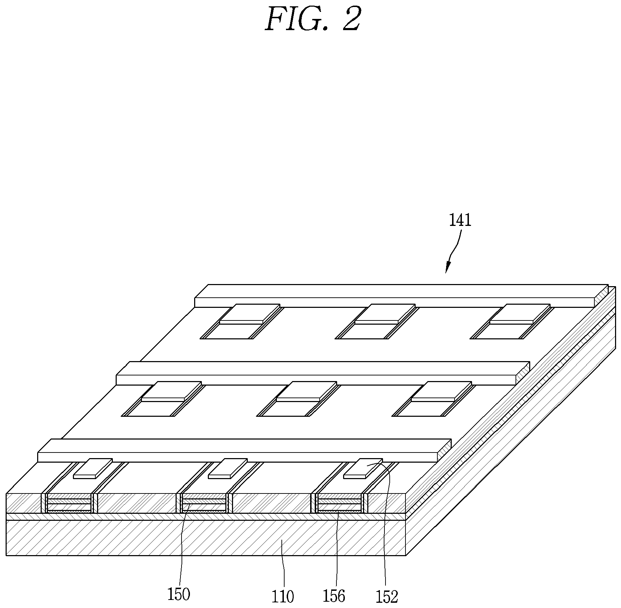

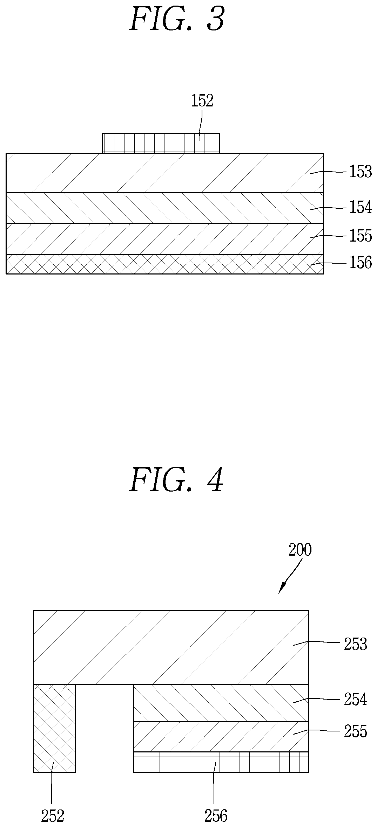

FIG. 1 is a schematic view illustrating a display device using a semiconductor light emitting element according to one implementation of the present disclosure, FIG. 2 is a partially enlarged view of a portion "A" of the display device in FIG. 1, FIG. 3 is an enlarged view of a semiconductor light emitting element of FIG. 2, and FIG. 4 is an enlarged view illustrating another implementation of the semiconductor light emitting element of FIG. 2.

As illustrated, information processed in a controller or control unit of a display device 100 may be displayed on a display module 140. A case 101 with a closed-loop shape surrounding an edge of the display module 140 may form a bezel of the display device 100.

The display module 140 may include a panel 141 on which an image is displayed, and the panel 141 may include semiconductor light emitting elements (or semiconductor light emitting devices) 150 with a micro size and a wiring substrate (or wiring board) 110 on which the semiconductor light emitting elements 150 are mounted.

A wiring is formed on the wiring substrate 110, so as to be connected to an n-type electrode 152 and a p-type electrode 156 of the semiconductor light emitting element 150. This may allow the semiconductor light emitting elements 150 to be provided on the wiring substrate 110 as self-emitting individual pixels.

An image displayed on the panel 141 is visual information, which is achieved by independently controlling light emission of sub-pixels arranged in a matrix form through the wiring.

The present disclosure exemplarily illustrates a micro light emitting diode (micro-LED) as one type of the semiconductor light emitting element 150 that converts current into light. The micro-LED may be a light emitting diode with a small size of 100 microns or less. The semiconductor light emitting element 150 may be provided in blue, red, and green light emitting regions to define a sub- pixel by a combination thereof. That is, the sub-pixel denotes a minimum unit for realizing one color, and at least three micro-LEDs may be provided in the sub-pixel.

More specifically, the semiconductor light emitting element 150 may have a vertical structure, as illustrated in FIG. 3.

For example, each of the semiconductor light emitting elements 150 may be implemented as a high-power light emitting element that emits various light colors including blue in a manner that gallium nitride (GaN) is mostly used, and indium (In) and/or aluminum (Al) are added thereto.

The vertical type semiconductor light emitting element may include a p-type electrode 156, a p-type semiconductor layer 155 formed on the p-type electrode 156, an active layer 154 formed on the p-type semiconductor layer 155, an n-type semiconductor layer 153 formed on the active layer 154, and an n-type electrode 152 formed on the n-type semiconductor layer 153. Here, the p-type electrode 156 located at the bottom may be electrically connected to a p-electrode of the wiring substrate, and the n-type electrode 152 located at the top may be electrically connected to a n-electrode at an upper side of the semiconductor light emitting element. The electrodes may be disposed in an upward/downward direction in the vertical semiconductor light emitting element 150, thereby providing a great advantage of reducing the chip size.

Alternatively, referring to FIG. 4, the semiconductor light emitting element may be a flip chip type light emitting element.

For example, a semiconductor light emitting element 250 may include a p-type electrode 256, a p-type semiconductor layer 255 on which the p-type electrode 256 is formed, an active layer 254 formed on the p-type semiconductor layer 255, an n-type semiconductor layer 253 formed on the active layer 254, and an n-type electrode 252 disposed on the n-type semiconductor layer 253 with being spaced apart from the p-type electrode 256 in a horizontal direction. Here, both the p-type electrode 256 and the n-type electrode 252 may be electrically connected to the p-electrode and the n-electrode of the wiring substrate at the bottom of the semiconductor light emitting element 250.

Each of the vertical type semiconductor light emitting element and the horizontal type semiconductor light emitting element may be a green semiconductor light emitting element, a blue semiconductor light emitting element, or a red semiconductor light emitting element. The green semiconductor light emitting element and the blue semiconductor light emitting element may each be implemented as a high-power light emitting element that emits green or blue light in a manner that gallium nitride (GaN) is mostly used, and indium (In) and/or aluminum (Al) are added thereto. For example, the semiconductor light emitting element may be a gallium nitride thin film consisting of various layers such as n-Gan, p-Gan, AIGaN, InGan, and the like. More specifically, the p-type semiconductor layer may be P-type GaN, and the n-type semiconductor layer may be N-type GaN. In the case of the red semiconductor light emitting element, the p-type semiconductor layer may be P-type GaAs, and the n-type semiconductor layer may be N-type GaAs.

In addition, a p-electrode side of the p-type semiconductor layer may be P-type GaN doped with Mg, and an n-electrode side of the n-type semiconductor layer may be N-type GaN doped with Si. In this case, the semiconductor light emitting elements described above may be semiconductor light emitting elements without an active layer.

Referring to FIGS. 1 to 4, since the light emitting diode is very small, the display panel may be configured such that self-emitting sub-pixels are arranged at fine pitch, thereby achieving a high-definition display device.

In a display device using the above-described semiconductor light emitting elements of the present disclosure, a semiconductor light emitting element grown on a wafer, and formed by mesa and isolation is used as an individual pixel. Here, the semiconductor light emitting element 150 with the micro size should be transferred onto a wafer at a predetermined position on the substrate of the display panel. Pick and place is one of those transfer techniques, which has a low success rate and requires much time. In addition, transferring several elements at once using a stamp or a roll can be used, which is poor in yield and is not suitable for a large screen display. Therefore, the present disclosure provides a new method for manufacturing a display device that can solve these problems and a manufacturing device using the same.

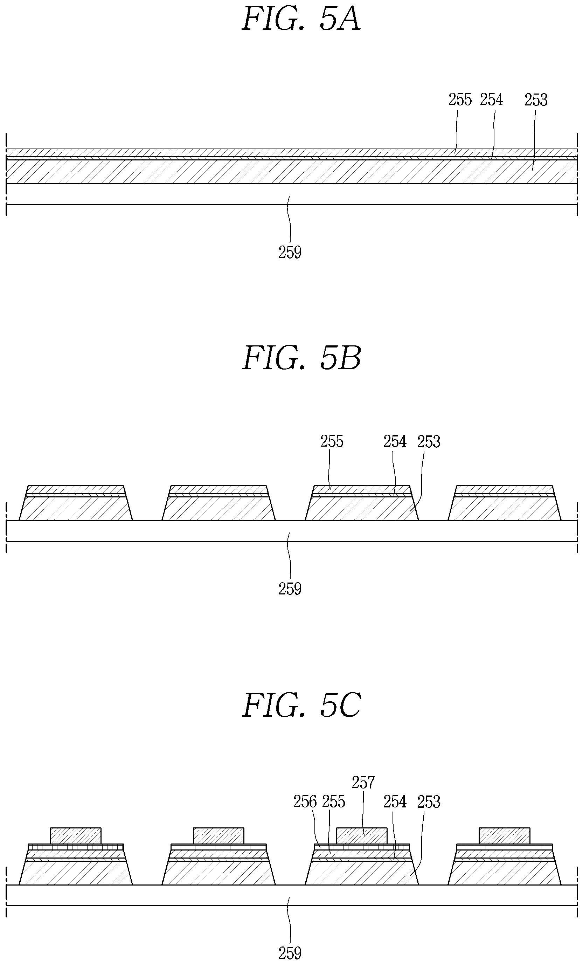

First of all, a new method for manufacturing a display device will be described hereinafter. FIGS. 5A to 5E are schematic views for explaining a new process of fabricating the semiconductor light emitting element.

A display device using a passive matrix (PM) type semiconductor light emitting element is illustrated herein. However, an example described hereinafter may also be applicable to an active matrix (AM) type semiconductor light emitting element. In addition, a method using a horizontal type semiconductor light emitting element is exemplified, but it is also applicable to a method of self-assembling a vertical type semiconductor light emitting element.

First, according to a manufacturing method, a first conductive semiconductor layer 253, an active layer 254, and a second conductive semiconductor layer 255 are grown on a growth substrate 259 (FIG. 5A).

When the first conductive semiconductor layer 253 is grown, the active layer 254 is grown on the first conductive semiconductor layer 253, and then the second conductive semiconductor layer 255 is grown on the active layer 254. As such, when the first conductive semiconductor layer 253, the active layer 254, and the second conductive semiconductor layer 255 are sequentially grown, the first conductive semiconductor layer 253, the active layer 254, and the second conductive semiconductor layer 255 form a layer structure as illustrated in FIG. 5A.

Here, the first conductive semiconductor layer 253 may be an n-type semiconductor layer, and the second conductive semiconductor layer 255 may be a p-type semiconductor layer. However, the present disclosure is not limited thereto, and the first conductive semiconductor layer 253 may be a p-type semiconductor layer, and the second conductive semiconductor layer 255 may be an n-type semiconductor layer.

In this implementation, the active layer is provided. However, in some cases, the active layer may not be present as described above. For example, the p-type semiconductor layer may be P-type GaN doped with Mg, and an n-electrode side of the n-type semiconductor layer may be N-type GaN doped with Si.

The growth substrate (wafer) 259 may be made of a material having optical transparency, such as sapphire (Al₂O₃), GaN, ZnO, and AIO, but the present disclosure is not limited thereto. In addition, the growth substrate 259 may be made of a material suitable for growing a semiconductor material, namely, a carrier wafer. The growth substrate 259 may also be formed of a material having high thermal conductivity, and use at least one of a SiC substrate having higher thermal conductivity than the sapphire (Al₂O₃) substrate, Si, GaAs, GaP, InP, and Ga₂O₃, in addition to a conductive substrate or an insulating substrate.

Next, at least portions or parts of the first conductive semiconductor layer 253, the active layer 254, and the second conductive semiconductor layer 255 are removed to form epi chips (or epi-chips) of a plurality of semiconductor light emitting elements (FIG. 5B).

More specifically, isolation is carried out such that a plurality of light emitting elements form an array with epi chips. That is, the first conductive semiconductor layer 253, the active layer 254, and the second conductive semiconductor layer 255 are etched in a vertical direction to form a plurality of semiconductor light emitting elements.

In case the horizontal type semiconductor light emitting element is formed in this step, the active layer 254 and the second conductive semiconductor layer 255 may be partially removed in the vertical direction to perform a mesa process in which the first conductive semiconductor layer 253 is exposed to the outside and an isolation process in which the first conductive semiconductor layer 253 is etched to form a plurality of semiconductor light emitting element arrays. However, in the present disclosure, as the mesa process is performed after a self-assembly process, the isolation process is carried out in this step without the mesa process. Here, the semiconductor light emitting element may be isolated to have a circular size of 100 µm or less in diameter.

Next, a second conductive electrode 256 (or p-type electrode) is formed on one surface of the second conductive semiconductor layer 255 (FIG. 5C). The second conductive electrode 256 may be formed by a deposition method such as sputtering, but the present disclosure is not limited thereto. However, when the first conductive semiconductor layer and the second conductive semiconductor layer are an n-type semiconductor layer and a p-type semiconductor layer, respectively, the second conductive electrode 256 may be an n-type electrode.

Then, a magnetic body 257 is stacked on the second conductive electrode 256. The magnetic body 257 may refer to a magnetic metal formed on an epi chip. The magnetic body 257 may be Ni, Sn, Fe, Co, or the like, or include a material corresponding to at least one of Gd-based, La-based, and Mn-based materials.

The magnetic body 257, which serves as a post for upper and lower division during the self-assembly afterward, may have an area corresponding to 25 to 75% of the epi chip area and a height of several hundred nanometers to several micrometers. However, the present disclosure is not limited thereto, and the magnetic body may be provided in the second conductive electrode 256 in the form of particles. As for a conductive electrode including a magnetic body, one layer of the conductive electrode may be formed of a magnetic body. For example, the second conductive electrode 256 may include a first inner layer and a second outer layer. Here, the first layer may include a magnetic body, and the second layer may include a metal material other than the magnetic body.

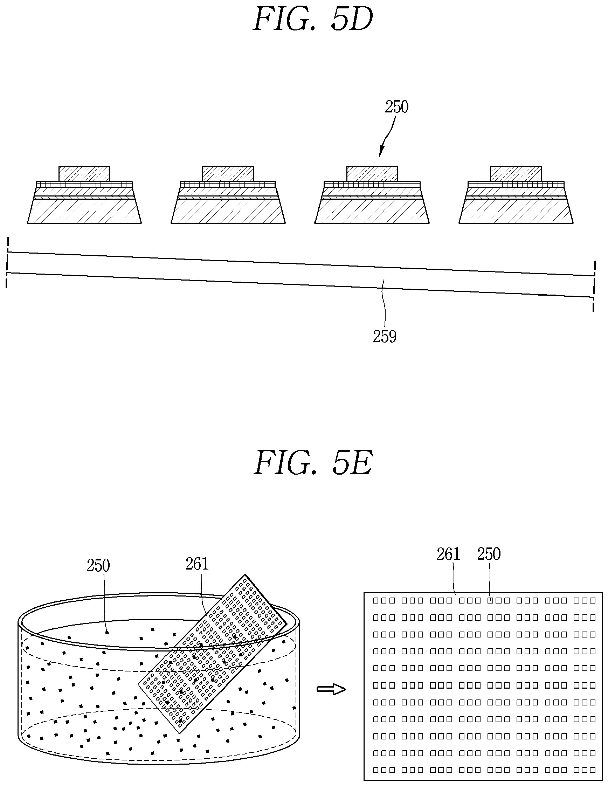

Next, the growth substrate 259 is removed to provide a plurality of semiconductor light emitting elements 250. For example, the growth substrate 259 may be removed using a laser lift-off (LLO) or chemical lift-off (CLO) method (FIG. 5D).

However, the plurality of semiconductor light emitting elements 250 in this step are epi chips, which do not have a complete structure in a subsequent process. Thereafter, a step of placing the plurality of semiconductor light emitting elements 250 on a substrate in a chamber filled with a fluid is performed (FIG. 5E).

For example, the semiconductor light emitting elements 250 and the substrate are put in a chamber filled with a fluid, and the semiconductor light emitting elements 250 are self-assembled on the substrate using the flow, gravity, surface tension, and the like.

In the present disclosure, the substrate may be a wiring substrate 261. In other words, the wiring substrate 261 is put into the fluid chamber so that the semiconductor light emitting elements 250 are directly seated on the wiring substrate 261.

In order to employ the self-assembly method described above in the manufacture of a large screen display, an increase in transfer yield is required. The present disclosure provides a method and a device for increasing the transfer yield.

To this end, in the display device according to the present disclosure, a magnetic force is applied to the magnetic bodies to move the semiconductor light emitting elements, and an electric field is used to place the semiconductor light emitting elements at preset or predetermined positions during the process of moving the semiconductor light emitting elements. Hereinafter, such a transfer method and a device will be described in more detail with reference to the accompanying drawings.

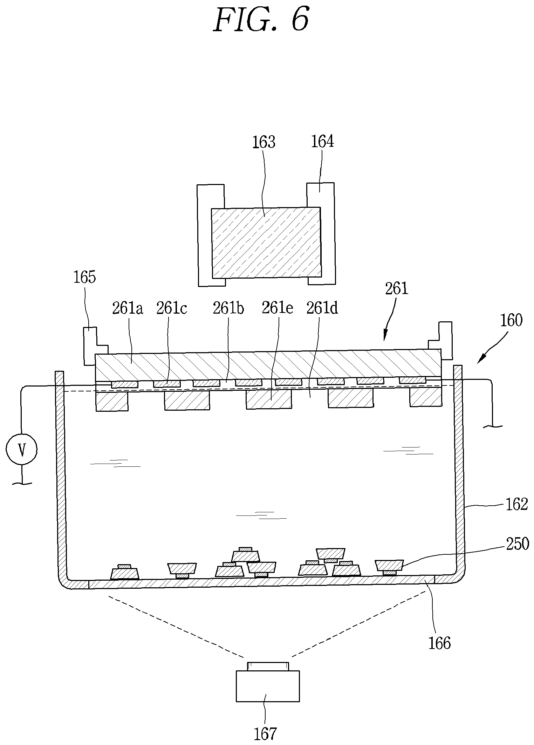

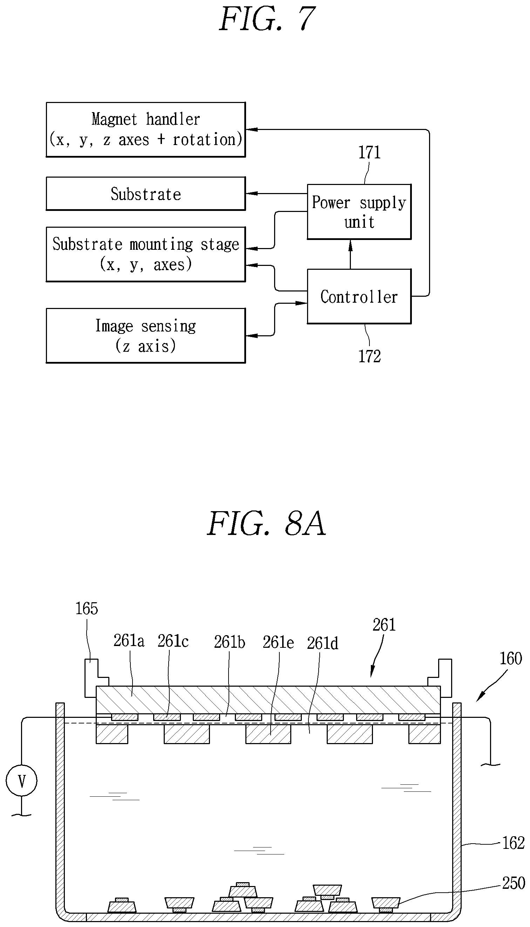

FIG. 6 is a schematic view showing an example of a self-assembly device for a semiconductor light emitting element according to the present disclosure, FIG. 7 is a block diagram illustrating the self-assembly device of FIG. 6, and FIGS. 8A to 8G are schematic views illustrating a process of self-assembling semiconductor light emitting elements using the self-assembly device of FIG. 6.

As illustrated in FIGS. 6 and 7, a self-assembly device 160 of the present disclosure may include a fluid chamber 162, a magnet 163, and a position controller 164.

The fluid chamber 162 has a space for accommodating a plurality of semiconductor light emitting elements. The space may be filled with a fluid, and the fluid may include water or the like as an assembly solution. The fluid chamber 162 may be a water tank and be configured as an open type. However, the present disclosure is not limited thereto, and the fluid chamber 162 may be configured as a closed type in which the space is closed.

A substrate (wiring substrate) 261 may be disposed on the fluid chamber 162 such that an assembly surface on which the semiconductor light emitting elements 250 are assembled faces downward. For example, the substrate 261 may be transferred to an assembly position by a transfer unit, and the transfer unit may include a stage 165 to which the substrate 261 is mounted. A position of the stage 165 is adjusted by a controller (or control unit), allowing the substrate 261 to be transferred to the assembly position.

At this time, the assembly surface of the substrate 261 faces the bottom of the fluid chamber 162 at the assembly position. As illustrated, the assembly surface of the substrate 261 is disposed to be immersed into a fluid in the fluid chamber 162, allowing the semiconductor light emitting elements 250 to move to the assembly surface in the fluid.

The substrate 261, which is an assembly substrate on which an electric field is formed and a wiring substrate on which wiring is formed afterward, may include a base portion 261a, a dielectric layer 261b, and a plurality of electrodes.

The base portion 261a may be made of an insulating material, and the plurality of electrodes may be a thin film or a thick bi-planar electrode patterned on one surface of the base portion 261a. Each of the plurality of electrodes may be formed of lamination of Ti/Cu/Ti, Ag paste, ITO, and the like, for example.

In more detail, the plurality of electrodes may be a plurality of pair electrodes 261c disposed on the substrate 261 and including a first electrode and a second electrode that generate an electric field when current is supplied.

The dielectric layer 261b may be made of an inorganic material such as SiO₂, SiNx, SiON, Al2O₃, TiO₂, HfO₂, and the like. Alternatively, the dielectric layer 261b may be an organic insulator consisting of a single layer or multiple layers. A thickness of the dielectric layer 261b may be several tens of nanometers (nm) to several micrometers (µm).

Further, the substrate 261 according to the present disclosure includes a plurality of cells 261d divided by partition walls.

For example, in order to allow the semiconductor light emitting elements 250 to be easily seated on the substrate 261, the substrate 261 may be provided with cells 261d to which the semiconductor light emitting elements 250 are fitted. In detail, the cells 261d on which the semiconductor light emitting elements 250 are placed are formed at the substrate 261 in positions where the semiconductor light emitting elements 250 are aligned with wiring electrodes. The semiconductor light emitting elements 250 are assembled to the cells 261d while moving in the fluid.

The cells 261d are sequentially arranged along one direction, and partition walls 261e defining the cells 261d are shared with neighboring cells 261d. Here, the partition walls 261e may each be made of a polymer material. In addition, the partition walls 261e may each protrude from the base portion 261a, and the cells 261d may be sequentially disposed along one direction by the partition walls 261e. More specifically, the cells 261d may be sequentially arranged in row and column directions and have a matrix structure.

As illustrated, each of the cells 261d is provided therein with a groove for accommodating the semiconductor light emitting element 250, and the groove may be a space defined by the partition walls 261e. A shape of the groove may be the same as or similar to a shape of the semiconductor light emitting element. For example, when the semiconductor light emitting element has a rectangular shape, the groove may also have a rectangular shape. Although not illustrated in the drawings, when the semiconductor light emitting element has a circular shape, the grooves formed in the cells may each have a circular shape. In addition, each of the cells is configured to accommodate a single semiconductor light emitting element. In other words, one semiconductor light emitting element is accommodated in one cell.

In the present disclosure, a material the same as the material of the partition walls 261e may be filled in the cells 261d in a subsequent process. Accordingly, the partitional walls 261e may be transformed into a passivation layer surrounding the semiconductor light emitting elements. This will be described later.

A plurality of electrodes may be disposed on the subrostrate 261 and include a first electrode and a second electrode that produce an electric field when current is supplied, and the first electrode and the second electrode may be referred to as a pair electrode 261c. In the present disclosure, the pair electrode 261c may be provided in plurality, so as to be disposed at the bottom of the respective cells 261d. The first electrode and the second electrode may each be formed of an electrode line, and the plurality of electrode lines may extend to neighboring cells.

The plurality of pair electrodes 261c are disposed below the cells 261d, and different polarities are applied to generate an electric field in the cells 261d. In order to produce the electric field, the dielectric layer 261b may cover the plurality of pair electrodes 261c to thereby define the bottom of the cells 261d. In this structure, when different polarities are applied to the pair electrode 261c from a lower side of each of the cells 261d, an electric field is produced, allowing the semiconductor light emitting elements 250 to be inserted into the cells 261d by the electric field.

In the assembly position, the electrodes of the substrate 261 are electrically connected to a power supply unit 171. The power supply unit 171 is configured to apply power to the plurality of electrodes to produce the electric field.

As illustrated, the self-assembly device 160 may include a magnet 163 for applying a magnetic force to the semiconductor light emitting elements 250. The magnet 163 is disposed to be spaced apart from the fluid chamber 162 to apply a magnetic force to the semiconductor light emitting elements 250. The magnet 163 may be disposed to face an opposite surface of the assembly surface of the substrate 261, and a position or location of the magnet 163 is controlled by the position controller 164 connected to the magnet 163. The semiconductor light emitting element 250 may include a magnetic body so as to move in the fluid by the magnetic field of the magnet 163.

In more detail, referring to FIGS. 6 and 7, the self-assembly device 160 may include a magnet handler that can be automatically or manually moved to x, y, and z axes at an upper side of the fluid chamber 162, or a motor capable of rotating the magnet 163. The magnet handler and the motor may construct the position controller 164. This may allow the magnet 163 to rotate in a horizontal direction, a clockwise direction, or a counterclockwise direction with respect to the substrate 161.

Meanwhile, a bottom plate 166 having optical transparency may be formed in the fluid chamber 162, and the semiconductor light emitting elements 250 may be disposed between the bottom plate 166 and the substrate 261. An image sensor 167 may be disposed to face the bottom plate 166 to monitor the inside of the fluid chamber 162 through the bottom plate 166. The image sensor 167 may be controlled by the controller 172, and include an inverted type lens, a CCD, and the like to observe the assembly surface of the substrate 261.

The self-assembly device described above uses a combination of a magnetic field and an electric field. When using these fields, the semiconductor light emitting elements may be placed at predetermined positions of the substrate by an electric field while moving according to a change of the position of the magnet 163. This new fabrication method may be a detailed example of the self-assembly method described above with reference to FIG. 5E. Hereinafter, an assembly process using the self-assembly device described above will be described in more detail.

First, a plurality of semiconductor light emitting elements 250 each having a magnetic body are formed through the process described with reference to FIGS. 5A to 5D. Here, the magnetic body may be deposited on the semiconductor light emitting element during the step of forming the second conductive electrode of FIG. 5C.

Next, a substrate 261 is transferred to an assembly position, and the semiconductor light emitting elements 250 are put into a fluid chamber 162 (FIG. 8A).

As described above, the assembly position of the substrate 261 may be configured such that the assembly surface of the substrate 261 on which the semiconductor light emitting elements 250 are assembled is disposed to face downward in the fluid chamber 162.

At this time, some of the semiconductor light emitting elements 250 may sink to the bottom of the fluid chamber 162 and some may float in the fluid. When the bottom plate 166 having optical transparency is provided in the fluid chamber 162, some of the semiconductor light emitting elements 250 may sink to the bottom plate 166.

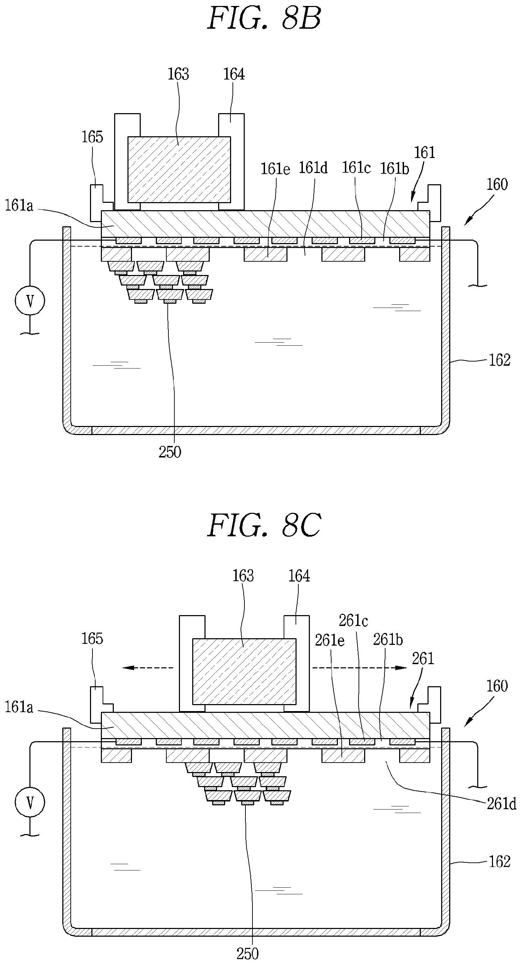

Next, a magnetic force is applied to the semiconductor light emitting elements 250 so that the semiconductor light emitting elements 250 float vertically in the fluid chamber 162 (FIG. 8B).

When the magnet 163 of the self-assembly device 160 moves from its original position to an opposite surface of the assembly surface of the substrate 261, the semiconductor light emitting elements 250 float in the fluid in a direction toward the substrate 261. The original position may be a position away from the fluid chamber 162. As another example, the magnet 163 may be configured as an electromagnet. In this case, electricity is supplied to the electromagnet to produce an initial magnetic force.

In this example, a separation distance between the assembly surface of the substrate 261 and the semiconductor light emitting elements 250 may be controlled by adjusting the magnitude of the magnetic force. For example, the separation distance is controlled using the weight, buoyancy, and magnetic force of the semiconductor light emitting elements 250. The separation distance may be several millimeters to several tens of micrometers from the outermost edge of the substrate 261.

Next, a magnetic force is applied to the semiconductor light emitting elements 250 so that the semiconductor light emitting elements 250 move in one direction in the fluid chamber 162. For example, when moving the magnet 163 in a horizontal direction, a clockwise direction, or a counterclockwise direction with respect to the substrate 261 (FIG. 8C), the semiconductor light emitting elements 250 move in a direction horizontal to the substrate 261 at a position spaced apart from the substrate 261 by the magnetic force.

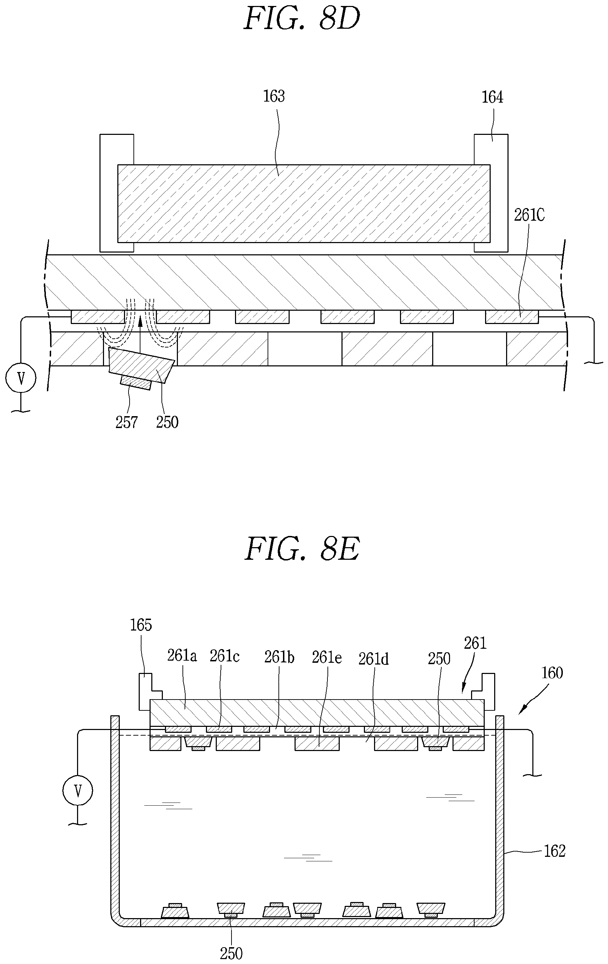

Then, an electric field is applied to guide the semiconductor light emitting elements 250 to predetermined positions, so as to allow the semiconductor light emitting elements 250 to be placed at the predetermined positions of the substrate 261 during the movement of the semiconductor light emitting elements 250 (FIG. 8D). For example, the semiconductor light emitting elements 250 move in a direction vertical to the substrate 261 by the electric field while moving in the direction horizontal to the substrate 261, causing the semiconductor light emitting elements 250 to be placed at the predetermined positions of the substrate 261.

The plurality of semiconductor light emitting elements are guided to predetermined positions of the substrate by an electric field and a magnetic field.

More specifically, power is supplied to the pair electrode of the substrate 261, namely, a bi-planar electrode to produce an electric field, allowing assembly to be performed only at predetermined positions. In other words, the semiconductor light emitting elements 250 are self-assembled at assembly positions of the substrate 261 using a selectively generated electric field. To this end, the substrate 261 may include cells in which the semiconductor light emitting elements 250 are inserted.

Here, the magnetic body 257 of the semiconductor light emitting elements 250 serves as a post for upper and lower division. In detail, when a surface having the magnetic body 257 is inserted into the cell in a direction toward the pair electrode 261c, the semiconductor light emitting element 250 cannot be seated on the bottom of the cell (outer surface of the dielectric layer) by the magnetic body 257.

After guiding the semiconductor light emitting elements 250 to the predetermined positions, the magnet 163 may be moved in a direction away from the substrate 261 so that semiconductor light emitting elements 250 remaining in the fluid chamber 162 fall to the bottom of the fluid chamber 162 (FIG. 8E). In the case of the magnet 163 configured as an electromagnet, semiconductor light emitting elements 250 remaining in the fluid chamber 162 may fall to the bottom of the fluid chamber 162 when power supply is stopped.

Then, the semiconductor light emitting elements 250 dropped on the bottom of the fluid chamber 162 are collected to be reused.

When the display device of the present disclosure uses blue semiconductor light emitting elements, that is, when the semiconductor light emitting elements are all blue semiconductor light emitting elements, the blue semiconductor light emitting elements may be assembled to all the cells of the substrate.

In this example, each of the red semiconductor light emitting element, the green semiconductor light emitting element, and the blue semiconductor light emitting element may be arranged at a desired position. If the semiconductor light emitting element 250 described above is a blue semiconductor light emitting element, an electric field is produced only in a cell corresponding to a blue pixel to assemble the blue semiconductor light emitting element to a corresponding position in the assembly process described with reference to FIGS. 8A to 8E.

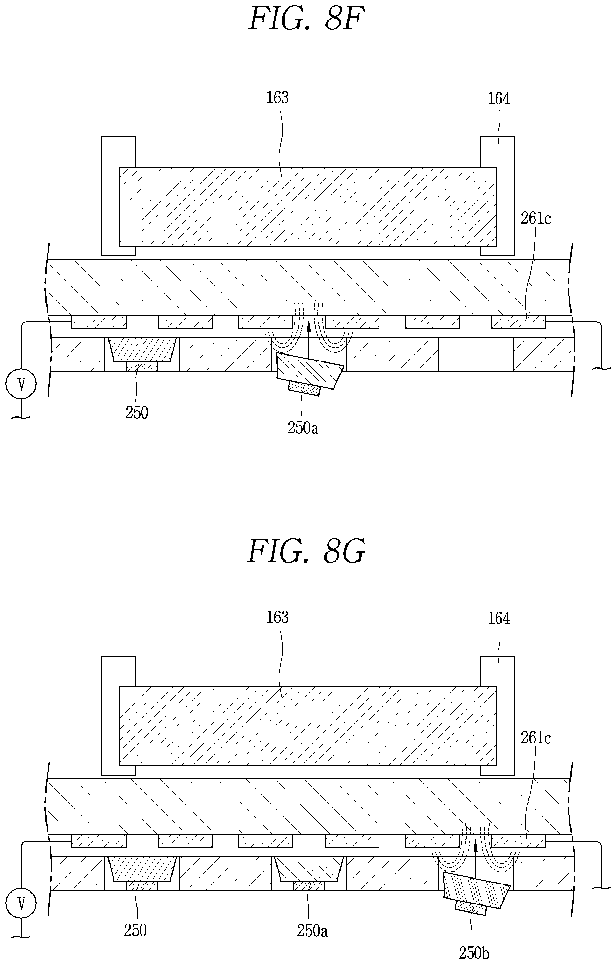

Then, the assembly process described with reference to FIGS. 8A to 8E is performed for a green semiconductor light emitting element 250a and a red semiconductor light emitting element 250b (FIGS. 8F and 8G). However, since the substrate 261 is already loaded at the assembly position, the process of loading the substrate 261 into the assembly position may be omitted.

Thereafter, the process of unloading the substrate 261 is performed, and the assembly process is completed.

In the self-assembly device and the method described above, parts at a far distance are concentrated adjacent to a predetermined assembly site using a magnetic field in order to increase the assembly yield in fluidic assembly, and an electric field is separately applied to the assembly site to selectively assemble the parts only in the assembly site. At this time, the assembly substrate is placed on an upper portion of the water tank in a manner that the assembly surface faces downward to thereby minimize the influence of gravity due to weight of the parts and suppress non-specific binding (or coupling), resulting in removing or preventing defects. That is, in order to increase the transfer yield, the assembly substrate is placed on the top to minimize the influence of gravity or frictional force, and prevent non-specific binding.

In addition, the blue semiconductor light emitting element, the green semiconductor light emitting element, and the red semiconductor light emitting element may be assembled at desired positions, respectively.

As described above, according to the present disclosure having the above-described configuration, a large number of semiconductor light emitting elements may be assembled at once in a display device in which individual pixels are formed with semiconductor light emitting elements.

Through the above-described process, the semiconductor light emitting elements 250, 250a, and 250b are disposed between the plurality of partition walls 261e. Here, a space may be formed between the semiconductor light emitting elements 250, 250a, and 250b and the partition walls 261e. When a gap between the partition walls 261e exactly matches a width of the semiconductor light emitting element, it is difficult to guide the semiconductor light emitting elements between the partition walls 261e during a self-assembly process. Accordingly, the gap between the partition walls 261e should be greater than the width of the semiconductor light emitting element, and thus, a space is generated between the semiconductor light emitting elements and the partition walls 261e.

Meanwhile, during the self-assembly, the semiconductor light emitting elements are fixed on the substrate by an electric field formed between the pair electrodes. However, when a voltage applied between the pair electrodes disappears after the self-assembly process is completed, an external force capable of fixing the semiconductor light emitting elements does not exist.

Since the spaces exist between the semiconductor light emitting elements and the partition walls 261e, the semiconductor light emitting elements may be separated from the predetermined positions when the post-process is performed after the self-assembly in a state that an external force that can fix the semiconductor light emitting elements is no longer present. The present disclosure provides a structure and a method for preventing a semiconductor light emitting element from being separated from a designated position during a process after the self-assembly. Hereinafter, the manufacturing process of the display device after the self-assembly will be described in detail with reference to the drawings.

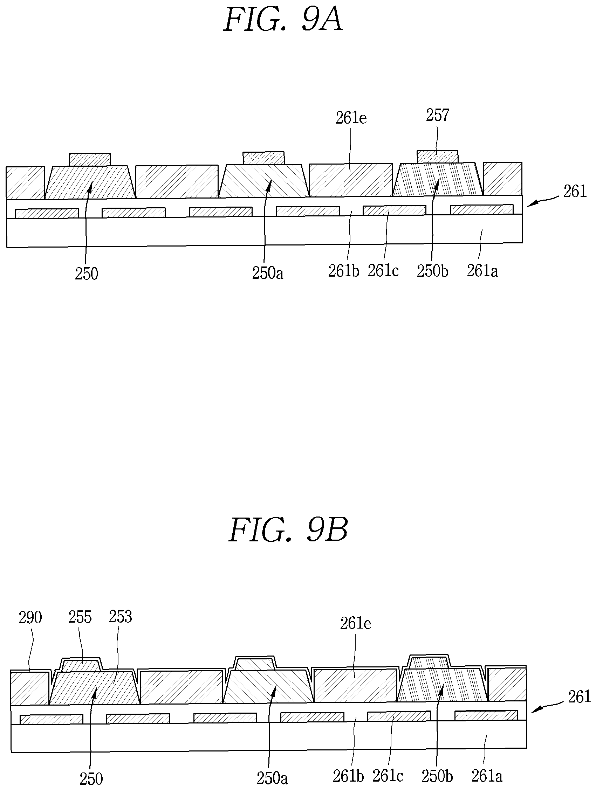

FIGS. 9A to 9E are schematic views illustrating a process of manufacturing a display device after self-assembling semiconductor light emitting elements to a wiring substrate using the self-assembly device of FIG. 6.

The movement of the semiconductor light emitting elements 250, 250a, and 250b in the fluid chamber are guided or induced so that the semiconductor light emitting elements 250, 250a, and 250b are assembled in predetermined positions of the substrate 261, and then the magnetic bodies 257 of the semiconductor light emitting elements 250, 250a, and 250b are removed (FIG. 9A).

In a state that the blue semiconductor light emitting element 250, the green semiconductor light emitting element 250a, and the red semiconductor light emitting element 250b are sequentially arranged in one direction as illustrated in FIG. 9A, the magnetic bodies 257 provided at the blue semiconductor light emitting element 250, the green semiconductor light emitting element 250a, and the red semiconductor light emitting element 250b are removed.

The magnetic bodies 257 may be removed by either a chemical method or a physical method, allowing the second conductive electrode 256 (see FIG. 5B) may be exposed to an outside of the cell. In addition, the semiconductor light emitting element may have a structure in which a magnetic body protrudes from the second conductive semiconductor layer 255 (see FIG. 5B) without the second conductive electrode 256. In this case, the second conductive semiconductor layer 255 may be exposed to an outside of the cell.

Next, a step of forming a passivation layer that covers at least portions or parts of the semiconductor light emitting elements and the partition walls is performed (FIG. 9B).

The passivation layer 290 serves to temporarily fix the semiconductor light emitting elements mounted on the substrate 261. In detail, after the self-assembly process, the passivation layer 290 allows the semiconductor light emitting elements to be held in position even when voltage is not applied to the pair electrode.

To this end, the passivation layer 290 covers a side surface of the partitional wall 261e, and extends from the side surface toward the semiconductor light emitting element so as to cover at least a portion of the semiconductor light emitting element. That is, as the passivation layer 290 covers both the partition walls 261e and the semiconductor light emitting elements, the semiconductor light emitting elements may be fixed.

Meanwhile, a portion of the passivation layer 290 may be formed on the substrate 261. More specifically, a space may exist between the semiconductor light emitting element and the partition wall 261e after the self-assembly. Accordingly, after the self-assembly is completed, a portion of the substrate 261 may be exposed to the outside. When the passivation layer 290 is formed in this state, the passivation layer may be formed on the portion of the substrate.

In this case, the passivation layer 290 may extend from a side surface of the partition wall 261e to the substrate 261, and then extend from the substrate 261 to a side surface of the semiconductor light emitting element. As the passivation layer 290 is formed on all of the partition wall 261e, the substrate 261, and the side surface of the semiconductor light emitting element, the semiconductor light emitting element may be fixed on the substrate.

The passivation layer 290 may be formed by a CVD method, and the like, but the present disclosure may not be limited thereto. The passivation layer 290 may be made of a dielectric thin film (e.g., SiO₂ or SiNx).

Meanwhile, a mesa formation step may be performed before or after the formation of the passivation layer. That is, at least one of the first conductive semiconductor layer 253 and the second conductive semiconductor layer 255 may be etched immediately after the self-assembly, or etched after the formation of the passivation layer 290.

In order to form a plurality of semiconductor light emitting elements, at least one of the first conductive semiconductor layer 253 and the second conductive semiconductor layer 255 is etched in a state that the semiconductor light emitting elements are assembled in predetermined positions of the substrate.

More specifically, the second conductive semiconductor layer 255 facing an outside of the cell is etched. Here, the second conductive electrode 256 and the active layer 254 (see FIG. 5B) may be etched together. As another example, when a magnetic body is directly formed on one surface of the conductive semiconductor layer without the second conductive electrode 256, the magnetic body may protrude from one surface of the etched semiconductor layer, either the first conductive semiconductor layer 253 or the second conductive semiconductor layer 255.

Through this etching, a portion of a surface opposite to a surface in contact with the dielectric layer 261b on the first conductive semiconductor layer 253 may be exposed to the outside. The portion exposed to the outside may not overlap an upper surface of the second conductive semiconductor layer 255, which may be a portion spaced apart in the horizontal direction. A flip-chip type semiconductor light emitting element is formed by such a mesa process.

When self-assembling mesa processed semiconductor light emitting elements, the mesa process is not performed after the self-assembly.

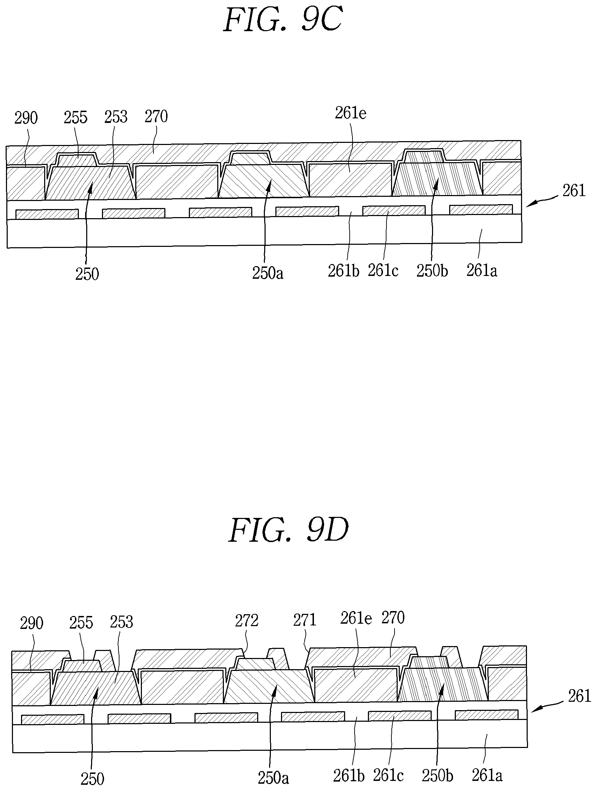

Next, a step of forming an optical gap layer is performed (FIG. 9C).

The optical gap layer 270 is formed to planarize the display device and fix the semiconductor light emitting elements. The self-assembled semiconductor light emitting elements may be fixed by only the optical gap layer 270, but positions of the semiconductor light emitting elements may be changed during the formation of the optical gap layer 270.

In detail, the optical gap layer 270 may be formed by applying a photosensitive organic insulator using a spray or spin coating, and then curing the organic insulator. When the organic insulator is applied in a state in which the semiconductor light emitting element is not fixed, the semiconductor light emitting element may be separated from a designated position due to the organic insulator.

In the present disclosure, as the semiconductor light emitting element is temporarily fixed by the passivation layer 290, the semiconductor light emitting element is not deviated from the designated position even when the organic insulator is applied.

The organic insulator is filled in spaces formed between the semiconductor light emitting elements and the partition walls 261e, and accordingly, a portion of the optical gap layer 270 is located between the semiconductor light emitting element and the partition wall 261e. When the passivation layer 290 is sufficiently thick, the optical gap layer 270 may not be positioned between the semiconductor light emitting element and the partition wall.

Next, a step of forming a contact hole is performed (FIG. 9D).

As illustrated, contact holes 271 and 272 may be formed for wiring. The contact holes 271 and 272 may be formed on the first conductive semiconductor layer 253 and the second conductive semiconductor layer 255, respectively. In this process, a portion of the passivation layer 290 may also be etched.

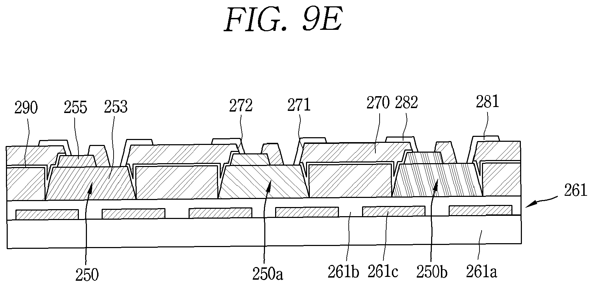

Finally, a step of connecting a first wiring electrode and a second wiring electrode to the plurality of semiconductor light emitting elements through the contact holes is performed (FIG. 9E).

As illustrated in FIG. 9E, the first wiring electrode 281 and the second wiring electrode 282 may extend to one surface of the optical gap layer 270. Here, one surface of the optical gap layer 270 may be a surface opposite to a surface facing the dielectric layer 261b. For example, the first wiring electrode 281 extends from the first conductive semiconductor layer 253 to an upper surface of the optical gap layer 270 through the first contact hole 271 formed on the first conductive semiconductor layer 253. The second wiring electrode 282 extends to an upper surface of the optical gap layer 270 through the second contact hole 272 formed on the second conductive semiconductor layer 255. As another example, when the second conductive electrode 256 (see FIG. 5D) is provided on an upper surface of the second conductive semiconductor layer 255, the second wiring electrode 282 may extend to an upper surface of the optical gap layer 270 through the second contact hole 272.

According to this structure, transfer may be performed by the self-assembly, and wiring of the flip-chip type semiconductor light emitting elements may be achieved. In this case, the optical gap layer 270 may be disposed on a front side of the display device 100 (see FIG. 1), and the first wiring electrode 281 and the second wiring electrode 282 may be transparent electrodes. Here, the pair electrode 261c made of a metal material may be used as a reflective layer.

According to the structure described above, portions of the first and second wiring electrodes 281 and 282 may overlap the passivation layer 290. Meanwhile, the partition wall 261e, the passivation layer 290, and the optical gap layer 270 may be sequentially stacked in a region or area where the partition wall is formed among the entire area of the substrate 261.

As described above, in the present disclosure, the passivation layer 290 is formed immediately after the self-assembly process to thereby temporarily fix the semiconductor light emitting elements to the substrate. This may prevent the semiconductor light emitting elements from being separated from their designated positions in a process subsequent to the self-assembly process.

The passivation layer 290 is a layer that is essentially formed when manufacturing the display device. According to the present disclosure, self-assembled semiconductor light emitting elements may be temporality fixed without adding a separate process.

Meanwhile, the passivation layer described above may consist of a plurality of layers. In detail, the passivation layer may include a first passivation layer that covers a portion of the semiconductor light emitting element, and a second passivation layer that covers at least a portion of the first passivation layer and at least a portion of the partition wall.

Hereinafter, a passivation layer including a plurality of layers will be described in detail with reference to the accompanying drawings.

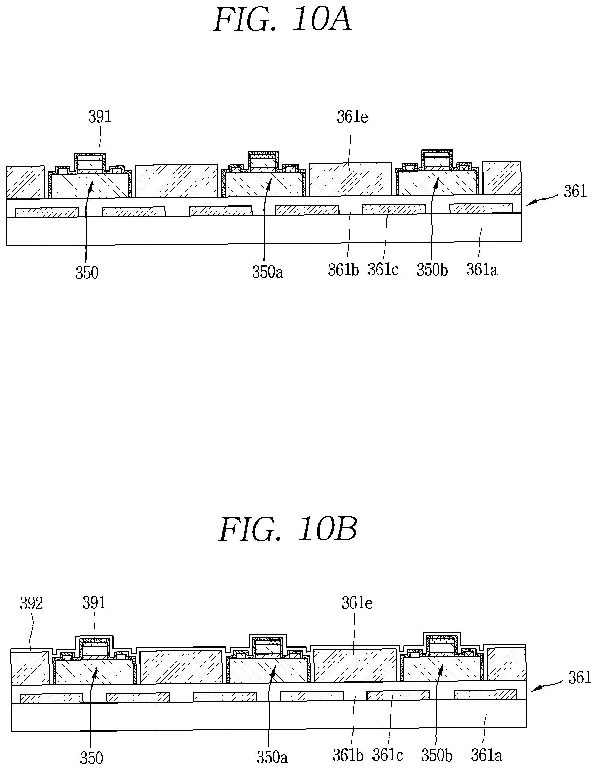

FIGS. 10A to 10E are schematic views illustrating a modified example of the present disclosure.

Referring to FIG. 10A, a self-assembly process may be performed in a state that a passivation layer is formed on a surface of a semiconductor light emitting element. Here, a first passivation layer 391 is formed on a surface of a semiconductor light emitting element placed between partition walls.

The first passivation layer 391 serves to prevent oxidation of the semiconductor light emitting element, but does not play a role of fixing the semiconductor light emitting element on a substrate. Therefore, a separate structure for temporarily fixing the semiconductor light emitting element is required.

To this end, a step of forming a second passivation layer 392 is performed (FIG. 10B).

The second passivation layer 392 serves to temporarily fix the semiconductor light emitting element on the substrate, similar to the passivation layer 290 described with reference to FIGS. 9A to 9E. The second passivation layer 392 covers a side surface of a partition wall 361e and extends from the side surface of the partition wall 361e toward semiconductor light emitting elements 350, 350a, and 350b. The second passivation layer 392 covers the first passivation layer 391 formed on the surface of the semiconductor light emitting element. That is, the second passivation layer 392 is formed on both the partition wall 361e and the first passivation layer 391 to thereby fix the semiconductor light emitting element to the substrate.

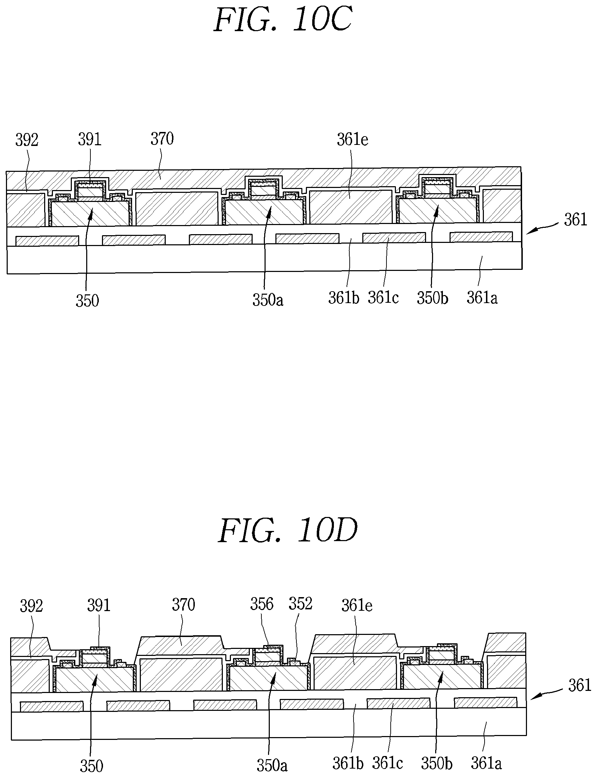

Next, a step of forming an optical gap layer is performed (FIG. 10C).

Similar to FIG. 9C, an optical gap layer 370 is formed to planarize the display device and fix the semiconductor light emitting elements. The self-assembled semiconductor light emitting elements may be fixed only by the optical gap layer 370, but positions of the semiconductor light emitting elements may be changed during the formation of the optical gap layer 370.

In the present disclosure, as the semiconductor light emitting element is temporarily fixed through the second passivation layer 392, the semiconductor light emitting element is not deviated from a designated position even when the organic insulator is applied.

The organic insulator is filled in spaces formed between the semiconductor light emitting elements and the partition walls 361e, and accordingly, a portion of the optical gap layer 370 is located between the semiconductor light emitting element and the partition wall. Meanwhile, when the second passivation layer 392 is sufficiently thick, the optical gap layer 370 may not be disposed between the semiconductor light emitting element and the partition wall.

Next, a step of forming a contact hole is performed (FIG. 10D).

As illustrated, a contact hole may be formed for wiring. The contact hole may be formed on each of a first conductive semiconductor layer 352 and a second conductive semiconductor layer 356. During this step, portions of the first passivation layer 391 and the second passivation layer 392 may also be etched together.

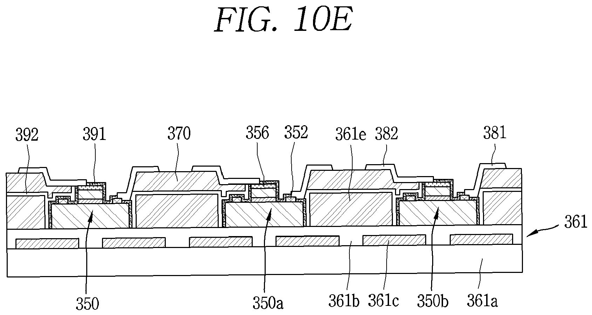

Finally, a step of connecting a first wiring electrode and a second wiring electrode to the plurality of semiconductor light emitting elements through the contact hole is performed (FIG. 10E).

Referring to FIGS. 10Ato 10E, a portion of the semiconductor light emitting element is covered by the first and second passivation layers. Light emitted from the semiconductor light emitting element passes through the first and second passivation layers and is then discharged to the outside. When the refractive index of the first passivation layer and the refractive index of the second passivation layer are sequentially changed, light loss due to total reflection in the passivation layers may be reduced. To this end, the first passivation layer and the second passivation layer may be made of different materials having different refractive indices.

Meanwhile, according to FIGS. 10A to 10E, the partition wall 361e is covered only by the second passivation layer 392. The partition wall 361e, the second passivation layer 392, and the optical gap layer 370 may be sequentially stacked in a region where the partition wall is formed among the entire region of the substrate.

According to the process and the device of the present disclosure, a large number of semiconductor light emitting elements may be pixelated on a wafer having a small size to be transferred onto a substrate with a large area. This may allow a large area display device to be manufactured at a low cost.

## Claims

1. A display device, comprising:
a substrate;
a plurality of partition walls disposed on the substrate;
a plurality of semiconductor light emitting elements disposed on the substrate and disposed between the partition walls; and
a passivation layer covering at least parts of the semiconductor light emitting elements and at least parts of the partition walls,
wherein the passivation layer extends from side surfaces of the plurality of partition walls in a direction toward the plurality of semiconductor light emitting elements, so as to cover at least parts of the side surfaces of the plurality of partition walls and at least parts of the plurality of semiconductor light emitting elements.

2. The display device of claim 1, further comprising:
an optical gap layer covering the passivation layer; and
a first wiring electrode and a second wiring electrode formed on the optical gap layer, and electrically connected to the plurality of semiconductor light emitting elements.

3. The display device of claim 2, wherein parts of the first and second wiring electrodes overlap the passivation layer.

4. The display device of claim 1, wherein a part of the passivation layer covers the substrate.

5. The display device of claim 4, wherein the passivation layer extends from side surfaces of the plurality of partition walls to the substrate, and extends from the substrate to side surfaces of the plurality of semiconductor light emitting elements.

6. The display device of claim 1, wherein the passivation layer includes:
a first passivation layer covering parts of the plurality of semiconductor light emitting elements; and
a second passivation layer covering at least a part of the first passivation layer and at least parts of the plurality of partition walls.

7. The display device of claim 6, wherein the first passivation layer and the second passivation layer are made of different materials having different refractive indices.

8. A method of self-assembling semiconductor light emitting elements, the method comprising:
disposing a plurality of partition walls on a substrate;
transferring the substrate to an assembly position, and putting the semiconductor light emitting elements each having a magnetic body into a fluid chamber;
applying a magnetic force to the semiconductor light emitting elements so as to allow the semiconductor light emitting elements to move along one direction in the fluid chamber;
applying an electric field to guide the semiconductor light emitting elements between the partition walls while moving, so that the semiconductor light emitting elements are placed between the partition walls; and
forming a passivation layer covering at least parts of the plurality of partition walls and at least parts of the semiconductor light emitting elements, so that the semiconductor light emitting elements placed between the partition walls are fixed.

9. The method of claim 8, further comprising forming an optical gap layer covering the passivation layer.
